# EUROPÄISCHE PATENTANMELDUNG

(11) **EP 1 874 105 A2**
(43) Veröffentlichungstag der Anmeldung: **02.01.2008**
(21) Anmeldenummer: 07109231.6
(22) Anmeldetag: 30.05.2007
(51) Int. Cl.: H05K 13/04

(54) **Erkennen von Produktwechseln bei der Leiterplattenbestückung**

(30) Priorität: 20.06.2006 DE 102006028350
(71) Anmelder: SIEMENS AKTIENGESELLSCHAFT, 80333 München (DE)
(72) Erfinder: Schlang, Martin, 81671, München (DE)

(57) **Zusammenfassung**

Die Erfindung beschreibt eine Verfahren zum Erkennen eines Produktwechsels bei der automatischen Bestückung von Leiterplatten (571, 572) mittels Bestückautomaten (500), Das Verfahren umfasst folgende Schritte: (a) Bestücken von zumindest einer ersten Leiterplatte (571) unter Verwendung eines ersten Bestückprogramms, (b) Zuführen eines Produktwechsel-Identifikationselementes (550), welches die Form einer Leiterplatte aufweist, (c) Identifizieren des Produktwechsel-Identifikationselementes (550) mittels einer Erfassungseinrichtung (527) des Bestückautomaten (500), und (d) Bestücken von zumindest einer zweiten Leiterplatte (572) unter Verwendung eines zweiten Bestückprogramms. Bevorzugt wird eine Leiterplattenkamera (525) zum Identifizieren des Produktwechsel-Identifikationselementes (550) verwendet. Damit kann zur Durchführung des Verfahrens ohnehin in einem Bestückautomaten vorhandene Sensorik verwendet werden.

## Beschreibung

Die vorliegende Erfindung betrifft die Bestückung von Leiterplatten mit Bauelementen mittels so genannter Bestückautomaten. Die Erfindung betrifft insbesondere ein Verfahren zum Erkennen eines Produktwechsels bei der automatischen Bestückung von Leiterplatten.

Die vorliegende Erfindung betrifft ferner einen Bestückautomat, welcher zur Durchführung des erfindungsgemäßen Verfahrens eingerichtet ist.

Außerdem betrifft die Erfindung ein computerlesbares Speichermedium sowie ein Programm-Element, welche Instruktionen zur Durchführung des erfindungsgemäßen Verfahrens zum Erkennen eines Produktwechsels enthalten.

Bei der automatischen Bestückung von Bauelementeträgern bzw. Leiterplatten in so genannten Bestückautomaten werden Bauelemente von einer Bauelemente-Zuführeinrichtung an bestimmten Abholpositionen bereitgestellt und dort von einem Bestückkopf abgeholt, welcher mittels eines Positioniersystems innerhalb eines Arbeitsbereiches positioniert werden kann. Die abgeholten Bauelemente werden von dem Bestückkopf zu einer Bestückposition transportiert und auf dem zu bestückenden Bauelementeträger an durch entsprechende Anschlussflächen definierte Einbaupositionen aufgesetzt.

Die Bestückung von Leiterplatten erfolgt dabei üblicherweise in Losen bzw. Chargen. Dabei ist jedem Los, welches eine bestimmte Anzahl an mit einem einheitlichen Bestückinhalt zu bestückenden Leiterplatten umfasst, ein bestimmtes Bestückprogramm zugeordnet. Bei einem Produkt- bzw. Loswechsel von einer ersten Charge von zu bestückenden Leiterplatten auf eine zweite Charge von zu bestückenden Leiterplatten wird der Bestückautomat mit einem entsprechend geänderten Bestückprogramm versorgt, sofern das geänderte Bestückprogramm nicht bereits dem Bestückautomaten bereitgestellt wurde. Das Aufspielen des geänderten Bestückprogramms erfolgt in der Regel offline durch einen eigenständigen Prozess, bei dem die entsprechenden Daten auf einen Rechnereinheit des Bestückautomaten übertragen werden.

Die Datenübertragung auf die Rechnereinheit kann bereits vor dem Loswechsel stattfinden, wobei das laufende Los erst fertig bestückt wird, bevor dem Bestückautomaten der eigentliche Produktwechsel durch einen Bedieneingriff mitgeteilt wird. Bei einer nicht korrekten zeitlichen Abstimmung zwischen dem Loswechsel und dem Bedieneingriff kann es zu Fehlbestückungen kommen, bei denen entweder ein nach einem Loswechsel zu bestückendes zweites Los mit dem Bestückprogramm des vorhergehenden Loses bestückt wird oder bei denen vor einem Loswechsel ein noch fertig zu bestückendes erstes Los bereits mit dem Bestückprogramm des nachfolgenden zweiten Loses bestückt wird.

Zur zeitlichen Synchronisation der Änderung eines Bestückprogramms mit einem Loswechsel ist es bekannt, die zu bestückenden Leiterplatten mit einem Barcode auszustatten, welcher von einem entsprechenden Lesegerät erfasst wird. Dies hat den Nachteil, dass die zu bestückenden Leiterplatten mit entsprechenden Barcodes versehen sein müssen und dass der Bestückautomat für eine automatische Erkennung eines Loswechsels mit einem derartigen Lesegerät ausgestattet werden muss.

Sofern Leiterplatten bestückt werden sollen, welche keine derartige Barcodes aufweisen, und/oder sofern der betreffende Bestückautomat kein entsprechendes Lesegerät aufweist, muss eine Bedienperson durch eine manuelle Eingabe an einem Eingabeeinrichtung des Bestückautomaten den Zeitpunkt des Loswechsel angeben bzw. bestätigen. Dies führt jedoch insbesondere bei einer unaufmerksamen Bedienperson häufig zu den oben genannten Fehlbestückungen.

Der Erfindung liegt die Aufgabe zugrunde, ein Verfahren anzugeben, mit dem auf einfache und gleichzeitig zuverlässige Weise Fehlbestückungen bei einem Produktwechsel vermieden werden können.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird ein Verfahren zum Erkennen eines Produktwechsels bei der automatischen Bestückung von Leiterplatten mittels Bestückautomaten angegeben. Das erfindungsgemäße Verfahren weist folgende Schritte auf: (a) Bestücken von zumindest einer ersten Leiterplatte unter Verwendung eines ersten Bestückprogramms, (b) Zuführen eines Produktwechsel-Identifikationselementes, welches die Form einer Leiterplatte aufweist, (c) Identifizieren des Produktwechsel-Identifikationselementes mittels einer Erfassungseinrichtung des Bestückautomaten, und (d) Bestücken von zumindest einer zweiten Leiterplatte unter Verwendung eines zweiten Bestückprogramms.

Dem erfindungsgemäßen Verfahren liegt die Erkenntnis zugrunde, dass ein Los- bzw. ein Produktwechsel von dem Bestückautomaten selbständig und zuverlässig erkannt werden kann, wenn der Bestückautomat die Zuführung einer so genannten Loswechselleiterplatte erkennt.

Gemäß der Erfindung ist jeweils einer Charge bzw. einem Los von Leiterplatten ein bestimmtes Bestückprogramm zugeordnet, welches die Bestückung des jeweiligen Leiterplatte sowohl hinsichtlich des Typs der zu bestückenden Bauelemente als auch hinsichtlich der Positionen der zu bestückenden Bauelemente steuert. Ferner können die Bestückprogramme auch eine bestimmte Bestückreihenfolge vorgeben, welche bevorzugt hinsichtlich der insgesamt erforderlichen Transportwege der Bauelemente optimiert ist. Durch eine Verkürzung der Bauelement-Transportwege von vorgegebenen Zuführpositionen an die jeweilige Bestückposition kann somit die für eine bestimmte Bestückung erforderliche Bestückzeit verkürzt und der Bestückprozess dementsprechend optimiert werden.

Das Produktwechsel-Identifikationselement kann dabei jede beliebige Leiterplatte sein, die sich sowohl von der ersten Leiterplatte als auch von der zweiten Leiterplatte unterscheidet.

Das erfindungsgemäße Verfahren hat den Vorteil, dass eine Bedienperson, welche im Rahmen einer Elektronikfertigung typischerweise mehrere Bestückautomaten bedient bzw. überwacht, durch die automatische Loswechselerkennung erheblich entlastet wird. Auf diese Weise werden Fehlerquellen für potentielle Bedienfehler ausgeschaltet und die gesamte Prozesssicherheit entsprechend erhöht.

Gemäß einem Ausführungsbeispiel der Erfindung nach Anspruch 2 wird das Produktwechsel-Identifikationselement einem Bestückbereich des Bestückautomaten zugeführt. Dies hat den Vorteil, dass zur Zuführung des Produktwechsel-Identifikationselements kein spezieller Zuführbereich bzw. keine spezielle Zuführvorrichtung erforderlich ist. Das genannte Verfahren kann damit auf einfache Weise in herkömmliche Bestückautomaten angewendet werden.

Gemäß einem weiteren Ausführungsbeispiel der Erfindung nach Anspruch 3 erfolgt das Zuführen des Produktwechsel-Identifikationselementes mittels eines Leiterplatten-Transportsystems. Dies hat den Vorteil, dass das Produktwechsel-Identifikationselement dem Bestückautomaten mit einem ohnehin bereits vorhandenen Leiterplatten-Transportsystem zugeführt werden kann. Dabei wird bevorzugt die Produktwechsel-Identifizierungsleiterplatte zwischen der letzten Leiterplatte der ersten Charge und der ersten Leiterplatte der zweiten Charge in den Bestückbereich eingeschleust und dort von der Erfassungseinrichtung des Bestückautomaten identifiziert.

Gemäß einem weiteren Ausführungsbeispiel der Erfindung nach Anspruch 4 unterscheidet sich das Produktwechsel-Identifikationselement hinsichtlich seines optischen Erscheinungsbildes sowohl von der ersten Leiterplatte als auch von der zweiten Leiterplatte. Dabei kann der Unterschied zwischen Produktwechsel-Identifikationselement und den beiden Leiterplatten beispielsweise durch eine unterschiedliche Farbe und/oder durch eine unterschiedliche optische Oberflächenbeschaffenheit verursacht werden.

Gemäß einem weiteren Ausführungsbeispiel der Erfindung nach Anspruch 5 weist das Produktwechsel-Identifikationselement im Vergleich zu den beiden Leiterplatten zumindest eine unterschiedliche Markierung aufweist. Dabei kann der Unterschied in den Markierungen beispielsweise mittels spezifischen lokalen Passmarken realisiert sein. Ebenso ist es jedoch möglich, dass das Produktwechsel-Identifikationselement gerade an der Stelle keine Markierung aufweist, an der an der ersten und/oder an der zweiten Leiterplatte eine Markierung vorgesehen ist.

Ferner ist es möglich, dass für das Produktwechsel-Identifikationselement und die beiden Leiterplatten gleichartige oder zumindest ähnliche Markierungen verwendet werden, die jedoch an unterschiedlichen Stellen angeordnet sind. Selbstverständlich können auch unterschiedliche Markierungen zur Unterscheidung zwischen Produktwechsel-Identifikationselement und den beiden Leiterplatten verwendet werden, wobei die unterschiedliche Markierungen an unterschiedlichen Stellen angeordnet sind.

Bei an unterschiedlichen Stellen angeordneten Markierungen kann die Identifikation des Produktwechsel-Identifikationselementes beispielsweise dadurch erfolgen, dass mittels einer verfahrbaren Kamera erst dann die Positionen der entsprechenden Markierungen des Produktwechsel-Identifikationselementes angefahren werden, wenn an den Stellen, an denen die zu bestückenden Leiterplatten üblicherweise Markierungen aufweisen, keine oder keine den beiden zu bestückenden Leiterplatten zugeordnete Markierungen gefunden werden.

Gemäß einem weiteren Ausführungsbeispiel der Erfindung nach Anspruch 6 weist das Produktwechsel-Identifikationselement eine Markierung auf, welche sich im wesentlichen über die gesamte Oberfläche des Produktwechsel-Identifikationselementes erstreckt. Dies hat den Vorteil, dass die Identifikation des Produktwechsel-Identifikationselementes durch eine Erfassung eines beliebigen Teils der Oberfläche des Produktwechsel-Identifikationselementes erfolgen kann. Eine gezielte Positionierung einer Kamera zur Erfassung entsprechender Markierungen ist dabei nicht erforderlich. Somit kann die Identifikation des Produktwechsel-Identifikationselementes innerhalb einer kurzen Zeitspanne erfolgen. Dadurch wird die Zeitspanne zwischen der Bestückung von zwei unterschiedlichen Losen verkürzt und somit die Effizienz eines Bestückautomaten dadurch erhöht, dass die entsprechende Nebenzeit verkürzt wird, in der keine Bestückung erfolgen kann.

Gemäß einem weiteren Ausführungsbeispiel der Erfindung nach Anspruch 7 wird als Erfassungseinrichtung eine Leiterplattenkamera verwendet wird. Dies hat den Vorteil, dass das genannte Verfahren mit einem herkömmlichen Bestückautomaten durchgeführt werden kann, welcher ohnehin eine so genannte Leiterplattenkamera aufweist. Somit wird auf vorteilhafte Weise von der ohnehin im Bestückautomaten vorhandenen Sensorik Gebrauch gemacht.

In diesem Zusammenhang wird darauf hingewiesen, dass eine Leiterplattenkamera typischerweise für eine genaue Positionsbestimmung einer in den Bestückbereich des Bestückautomaten eingebrachten Leiterplatte verwendet wird. Dabei werden spezielle Markierungen (sog. Fiducials) auf der jeweils zu bestückenden Leiterplatte erfasst und deren Position mittels eines Bildverarbeitungsprogramms ermittelt. Durch eine entsprechende Ansteuerung eines Bestückkopfes können ggf. vorhandene Abweichungen der Markierungspositionen von vorgegebenen Sollpositionen beim Aufsetzen der Bauelemente kompensiert und somit eine hochgenaue Bestückung der Leiterplatte gewährleistet werden.

Gemäß einem weiteren Ausführungsbeispiel der Erfindung nach Anspruch 8 werden nach dem Identifizieren des Produktwechsel-Identifikationselementes Daten über eine Charge von zweiten Leiterplatten von dem Bestückautomaten eingelesen. Dabei erfolgt das Einlesen bevorzugt vor dem Bestücken von zumindest einer zweiten Leiterplatte. Ferner werden die Daten bevorzugt in codierter Form auf dem Produktwechsel-Identifikationselement und/oder auf einem separaten Informationselement abgelegt, wobei das separate Informationselement ebenfalls die Form einer Leiterplatte aufweist.

Wie oben bereits erläutert, werden die Daten bevorzugt durch die Leiterplattenkamera erfasst und von der Steuerungssoftware des Bestückautomaten eingelesen, ggf. entschlüsselt und weiter verarbeitet. Die Daten können auf einem zweidimensionalen Codierungsfeld gespeichert sein, welches bevorzugt von der Leiterplattenkamera des Bestückautomaten erfasst wird. Dabei kann in vorteilhafter Weise das Codierungsfeld erst dann vermessen werden, wenn bei der optischen Erfassung des Produktwechsel-Identifikationselements 450 an den entsprechenden Stellen, an denen bei einer zu bestückenden Leiterplatte Markierungen angebracht sind, keine Markierungen gefunden werden.

Die Daten können beispielsweise Informationen über die jeweiligen Leiterplatten wie beispielsweise Hersteller, Ort der Herstellung, Herstellzeitpunkt, Leiterplattentyp, Lieferscheinnummer, Anliefermenge, etc. enthalten. Auf diese Weise kann eine sog. Traceability, d.h. eine Nachverfolgbarkeit der für die Bestückung verwendeten Komponenten realisiert werden. Somit können bei dem Auftreten von Defekten bei fertig bestückten elektronischen Baugruppen mögliche Fehler schneller und einfacher identifiziert und frühzeitig ggf. erforderliche Rückrufaktionen von bereits an Kunden gelieferten Baugruppen veranlasst werden.

Gemäß einem weiteren Ausführungsbeispiel der Erfindung nach Anspruch 9 wird mit dem Identifizieren des Produktwechsel-Identifikationselementes der Bestückautomat zu einem vorbestimmten Produktwechsel-Sonderablauf veranlasst. Dies hat den Vorteil, dass der betreffende Bestückautomat zwischen dem ersten Bestückprogramm und dem zweiten Bestückprogramm in einen hinsichtlich der Produktwechselerkennung optimierten Betriebszustand versetzt werden kann.

Gemäß einem weiteren Ausführungsbeispiel der Erfindung nach Anspruch 10 umfasst der Produktwechsel-Sonderablauf zumindest einen der folgenden Verfahrensschritte: (a) Abführen des Produktwechsel-Identifikationselementes, (b) Umschalten des Bestückprogramms von dem ersten Bestückprogramm auf das zweite Bestückprogramm, (c) Ausgabe einer Produktwechsel-Information an einer Anzeigeeinrichtung, (d) Übergabe einer Produktwechsel-Information an eine Steuereinrichtung des Bestückautomaten, und (e) Fortsetzung der Bestückung mit dem zweiten Bestückprogramm.

Das Abführen des Produktwechsel-Identifikationselementes erfolgt bevorzugt über einen zügigen Transport des Produktwechsel-Identifikationselementes durch den Bestückautomaten hindurch. Dafür kann in vorteilhafter Weise ein Leiterplattentransport verwendet werden, mit dem die zu bestückenden bzw. die bereits bestückten Leiterplatten durch den Bestückautomaten transportiert werden.

Die Ausgabe einer Produktwechsel-Information an einer Anzeigeeinrichtung kann z. b. an einem User Interface erfolgen, welches einen Bildschirm aufweist, auf dem Informationen über das aktuelle Bestückprogramm angezeigt werden.

Die Übergabe einer Produktwechsel-Information kann auch von der Steuereinrichtung des Bestückautomaten weiter auf einen Leitrechner, auf ein sog. Monitoring System oder direkt an ein Manufacturing Execution System (MES) einer gesamten Bestücklinie mit mehreren Bestückautomaten erfolgen, so dass die Information über einen Produktwechsel auch von anderen Bestückautomaten berücksichtigt werden kann.

Mit dem unabhängigen Patentanspruch 11 wird ein Bestückautomat zum Bestücken von Leiterplatten mit Bauelementen beschrieben. Der erfindungsgemäße Bestückautomat weist mindestens einen Prozessor auf, der derart eingerichtet ist, dass das oben genannte Verfahren zum Erkennen von Loswechseln durchgeführt werden kann.

Mit dem unabhängigen Patentanspruch 12 wird eine computerlesbares Speichermedium beschrieben, in welchem ein Bearbeitungsprogramm für einen Bestückautomaten zum Bestücken von Leiterplatten mit Bauelementen gespeichert ist. Wenn das Programm von einem Prozessor ausgeführt wird, kann das oben beschriebene Verfahren zum Erkennen von Loswechseln durchgeführt werden.

Mit dem unabhängigen Patentanspruch 13 wird ein Programm-Element zum Bestücken von Leiterplatten mit Bauelementen beschrieben. Wenn das Programm-Element von einem Prozessor ausgeführt wird, kann das oben beschriebene Verfahren zum Erkennen von Loswechseln durchgeführt werden.

Das Programm-Element kann als computerlesbarer Anweisungscode in jeder geeigneten Programmiersprache wie beispielsweise in JAVA, C++ etc. implementiert sein. Das Programm-Element kann auf einem computerlesbaren Speichermedium (CD-Rom, DVD, Wechsellaufwerk, flüchtiger oder nicht-flüchtiger Speicher, eingebauter Speicher/Prozessor etc.) abgespeichert sein. Der Anweisungscode kann einen Computer oder andere programmierbare Geräte derart programmieren, dass die gewünschten Funktionen ausgeführt werden. Ferner kann das Programm-Element in einem Netzwerk wie beispielsweise dem Internet bereitgestellt werden, von dem es bei Bedarf von einem Nutzer herunter geladen werden kann.

Die Erfindung kann sowohl mittels eines Computerprogramms, d.h. einer Software, als auch mittels einer oder mehrerer spezieller elektrischer Schaltungen, d.h. in Hardware oder in beliebig hybrider Form, d.h. mittels Software-Komponenten und Hardware-Komponenten, realisiert werden.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1: eine bekannte Leiterplatte mit Markierungen zum Erkennen der Position der Leiterplatte in einem Bestückautomaten,
- Figuren 2a bis 2e: Ausführungsformen für mögliche lokale Passmarken einer Loswechselleiterplatte,
- Figur 3a: eine Produktwechsel-Identifikationsleiterplatte mit drei lokalen Passmarken,
- Figur 3b: eine Produktwechsel-Identifikationsleiterplatte einer ganzflächigen Markierung,
- Figur 3c: eine Produktwechsel-Identifikationsleiterplatte ohne eine spezielle Markierung,
- Figur 4: eine Produktwechsel-Identifikationsleiterplatte mit einem Datenträger, und
- Figur 5: eine Bestückvorrichtung mit einer Rechnereinheit zur Steuerung des Verfahrens zur Erkennung eines Leiterplatten-Produktwechsels.

An dieser Stelle bleibt anzumerken, dass sich in der Zeichnung die Bezugszeichen von gleichen oder von einander entsprechenden Komponenten lediglich in ihrer ersten Ziffer unterscheiden.

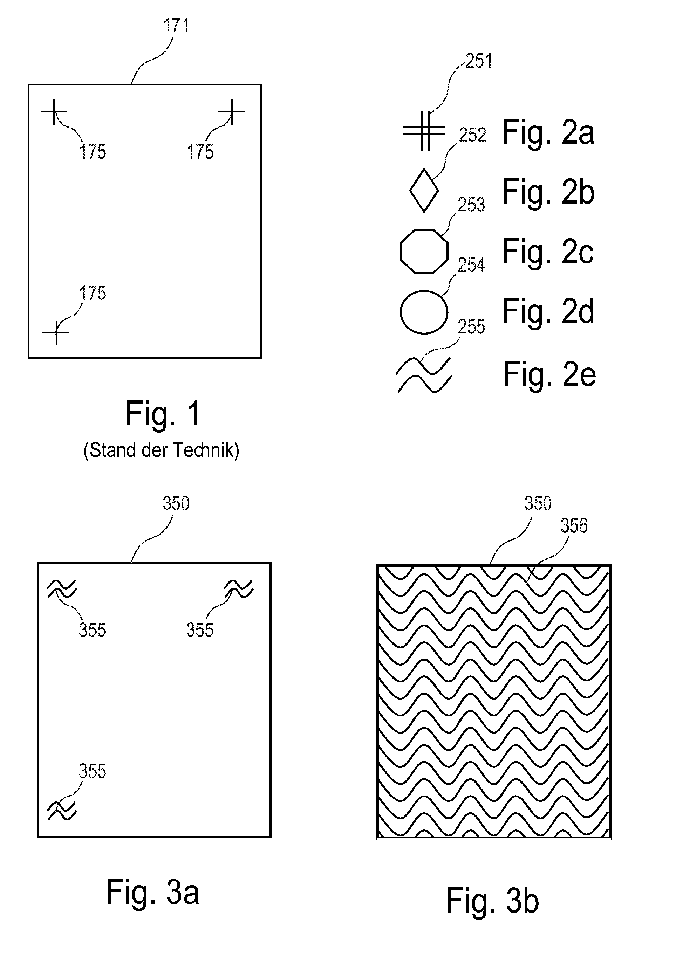

Figur 1 zeigt eine aus dem Stand der Technik bekannte Leiterplatte 171, welche drei Markierungen 175 (sog. Fiducials) aufweist: Die Markierungen 175 sind bei allen Leiterplatten 171 der selben Charge jeweils an derselben Stelle auf der Oberfläche der Leiterplatte 171 angebracht. Die Markierungen 175 dienen einer genauen Vermessung der Position der Leiterplatte 171, wenn die Leiterplatte 171 in einem Bestückbereich eines Bestückautomaten beispielsweise mittels eines Leiterplatten-Transportsystems eingefahren ist. Nur wenn die exakte Positionierung der Leiterplatte 171 bekannt ist, können elektronische Bauelemente an vorgegebenen Einbaupositionen auf der Leiterplatte 171 mit hoher Genauigkeit aufgesetzt werden.

Die Figuren 2a bis 2e zeigen mögliche Markierungen, die für eine modifizierte Leiterplatte verwendet werden können. Die modifizierte Leiterplatte soll gemäß einem Ausführungsbeispiel der Erfindung zwischen eine erste und eine zweite Leiterplatte in den Bestückautomaten eingefahren werden, wobei die erste Leiterplatte einem ersten Los und die zweite Leiterplatte einem zweiten Los zugeordnet ist. Anhand der speziellen Markierungen der modifizierte Leiterplatte, welche hier auch als Loswechsel- oder Produktwechsel-Identifikationsleiterplatte bezeichnet wird, kann der Bestückautomat erkennen, dass ein Loswechsel ansteht. Dementsprechend kann das auszuführende Bestückprogramm von einem ersten, dem ersten Los zugeordneten Bestückprogramm auf ein zweites, dem zweiten Los zugeordnetes Bestückprogramm geändert werden.

Wie aus den Figuren 2a bis 2e ersichtlich, kann die auf der Produktwechsel-Identifikationsleiterplatte aufgebrachte Markierung in vielfältiger Weise ausgebildet sein. Bevorzugt unterscheiden sich die Markierungen auf der Produktwechsel-Identifikationsleiterplatte in signifikanter Weise von den Markierungen der zu bestückenden Leiterplatten. Als mögliche Markierungen für eine Produktwechsel-Identifikationsleiterplatte kommt beispielsweise ein Doppelkreuz 251, eine Raute 252, ein regelmäßiges Achteck 253, ein Kreis 254 oder auch ein Wellensymbol 255 in Frage.

Es wird darauf hingewiesen, dass die Markierungen der Produktwechsel-Identifikationsleiterplatte auch den Markierungen 175 der zu bestückenden Leiterplatte 171 ähnlich oder sogar identisch sein können. In diesem Fall kann die Produktwechsel-Identifikationsleiterplatte von den zu bestückenden Leiterplatten dadurch unterscheidbar sein, dass die Markierungen im Vergleich zu der Leiterplatte 171 an unterschiedlichen Stellen auf der Produktwechsel-Identifikationsleiterplatte angebracht sind.

Figur 3a zeigt eine Produktwechsel- bzw. Loswechsel-Identifikationsleiterplatte 350, auf welcher drei Wellensymbole 355 angebracht sind. Die Wellensymbole 355 unterscheiden sich in signifikanter Weise von den Markierungen 175 der zu bestückenden Leiterplatte 171.

Figur 3b zeigt eine Loswechsel-Identifikationsleiterplatte 350, welche als identifizierbare Markierung ein durchgehendes, ganzflächiges Wellenmuster 356 aufweist. Zu einer Identifizierung der Identifikationsleiterplatte 350 kann mittels einer Kamera jeder beliebige Ausschnitt des Oberfläche der Identifikationsleiterplatte 350 optisch erfasst und mittels einer der Kamera nachgeschalteten Bildauswerteeinrichtung erkannt werden.

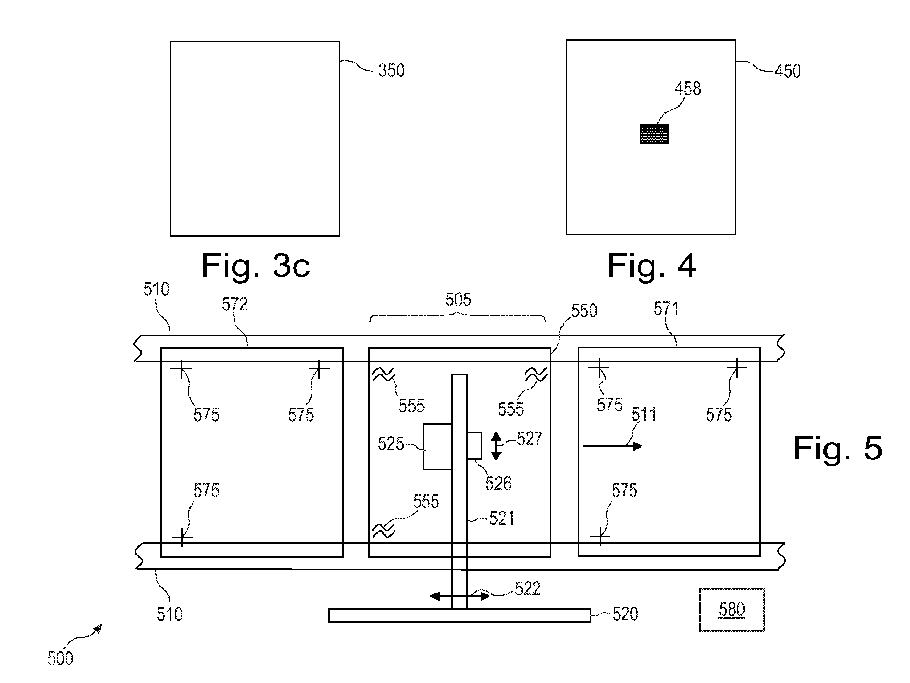

Figur 3c zeigt eine Loswechsel-Identifikationsleiterplatte 350, welche im Gegensatz zu einer zu bestückenden Leiterplatte keinerlei aufgebrachte Markierungen aufweist. Demzufolge kann für die Identifikationsleiterplatte 350 jedes beliebiges plattenförmige Element verwendet werden, welche die gleichen oder zumindest ähnliche Abmessungen wie die zu bestückenden Leiterplatten aufweist.

Figur 4 zeigt eine Produktwechsel-Identifikationsleiterplatte 450, welche in der Mitte der Leiterplatten-Oberfläche ein Codierungsfeld 458 aufweist. Selbstverständlich kann das Codierungsfeld 458 auch an anderer Stelle auf der Identifikationsleiterplatte 450 angeordnet sein. Das Codierungsfeld kann von einer Leiterplattenkamera des Bestückautomaten erfasst werden. Dabei wird bevorzugt das Codierungsfeld 458 erst dann erfasst, wenn bei der optischen Erfassung der Identifikationsleiterplatte 450 an den entsprechenden Stellen, an denen bei einer zu bestückenden Leiterplatte Markierungen angebracht sind, keine Markierungen gefunden wurden.

Gemäß dem hier dargestellten Ausführungsbeispiel enthalten die Daten Informationen über die jeweiligen Leiterplatten wie beispielsweise Hersteller, Ort der Herstellung, Herstellzeitpunkt, Leiterplattentyp, Lieferscheinnummer, Anliefermenge, etc. Auf diese Weise kann eine sog. Traceability, d.h. eine Nachverfolgbarkeit der für die Bestückung verwendeten Komponenten realisiert werden.

Figur 5 zeigt eine Bestückvorrichtung 500, welche zur Durchführen einer automatischen Loswechselidentifikation eingerichtet ist. Der Bestückautomat 500 weist ein Leiterplatten-Transportsystem 510 auf, mit dem Leiterplatten 571, 572 entlang einer Transportrichtung 511 einem Bestückbereich 505 zugeführt werden. Selbstverständlich werden nach einer erfolgten Bestückung die bestückten Leiterplatten 571, 572 aus dem Bestückbereich 505 entfernt.

Das Verfahren zur Identifikation eines Loswechsels beginnt mit der Bestückung einer Leiterplatte 571, die zum Zwecke der genauen Positionsvermessung, welche in dem Bestückbereich 505 durchgeführt wird, Markierungen 575 aufweist. Die Bestückung erfolgt mittels eines Bestückkopfes 525, welcher zusammen mit einer Leiterplattenkamera 526 an einem Trägerarm 521 verschiebbar gelagert ist. Der Trägerarm 521 ist mittels eines nicht dargestellten Schlittens an einer Linearführung 520 entlang der Bewegungsrichtung 522 verschiebbar gelagert. Durch eine gezielte Überlagerung der beiden Bewegungen 522 und 527 kann sowohl mit dem Bestückkopf 525 als auch mit der Leiterplattenkamera jede Position des Bestückbereiches 505 angefahren werden.

Nach der Bestückung der Leiterplatte 571, welche die letzte Leiterplatte in einem ersten Los von Leiterplatten darstellt, wird die Leiterplatte 571 aus dem Bestückbereich 505 heraus gefahren. Gleichzeitig wird eine Produktwechsel-Identifikationsleiterplatte 550 in den Bestückbereich 505 eingefahren. Die Produktwechsel-Identifikationsleiterplatte 550 weist spezielle Markierungen 555 auf, die sich von den Markierungen 575 in signifikanter Weise unterscheiden. Nach einem Erkennen der Markierungen 555 als Loswechsel-Identifikationsmarkierungen wird in einer Rechnereinheit 580 zur Steuerung des Bestückautomaten 500 ein geändertes Bestückprogramm gewählt. Mit diesem geänderten Bestückprogramm werden nach einem Entfernen der Produktwechsel-Identifikationsleiterplatte 550 und einem Einfahren einer Leiterplatte 572, welche die erste Leiterplatte eines zweiten Loses ist, sämtliche Leiterplatten 572 des zweiten Loses bestückt.

Zum Zwecke eines sicheren Leiterplatten-Transportes sind die Leiterplatten 571 und 572 sowie die Produktwechsel-Identifikationsleiterplatte 550 mittels jeweils einer aus Gründen der Übersichtlichkeit nicht dargestellten Leiterplattenklemmung fixiert.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

## Patentansprüche

1. Verfahren zum Erkennen eines Produktwechsels bei der automatischen Bestückung von Leiterplatten (571, 572) mittels Bestückautomaten (500), aufweisend folgende Schritte:
• Bestücken von zumindest einer ersten Leiterplatte (571) unter Verwendung eines ersten Bestückprogramms,
• Zuführen eines Produktwechsel-Identifikationselementes (550), welches die Form einer Leiterplatte aufweist,
• Identifizieren des Produktwechsel-Identifikationselementes (550) mittels einer Erfassungseinrichtung (527) des Bestückautomaten (500), und
• Bestücken von zumindest einer zweiten Leiterplatte (572) unter Verwendung eines zweiten Bestückprogramms.

2. Verfahren nach Anspruch 1, bei dem
das Produktwechsel-Identifikationselement (550) einem Bestückbereich (505) des Bestückautomaten (500) zugeführt wird.

3. Verfahren nach einem der Ansprüche 1 bis 2, bei dem
das Zuführen des Produktwechsel-Identifikationselementes (550) mittels eines Leiterplatten-Transportsystems (510) erfolgt.

4. Verfahren nach einem der Ansprüche 1 bis 3, bei dem
sich das Produktwechsel-Identifikationselement (550) hinsichtlich seines optischen Erscheinungsbildes sowohl von der ersten Leiterplatte (571) als auch von der zweiten Leiterplatte (572) unterscheidet.

5. Verfahren nach Anspruch 4, bei dem
das Produktwechsel-Identifikationselement (550) im Vergleich zu den beidem Leiterplatten (571, 572) zumindest eine unterschiedliche Markierung (555) aufweist.

6. Verfahren nach einem der Ansprüche 4 bis 5, bei dem
das Produktwechsel-Identifikationselement (350, 550) eine Markierung (356) aufweist, welche sich im Wesentlichen über die gesamte Oberfläche des Produktwechsel-Identifikationselementes (350) erstreckt.

7. Verfahren nach einem der Ansprüche 4 bis 6, bei dem
als Erfassungseinrichtung eine Leiterplattenkamera (526) verwendet wird.

8. Verfahren nach einem der Ansprüche 1 bis 7, bei dem
nach dem Identifizieren des Produktwechsel-Identifikationselementes (550) Daten über eine Charge von zweiten Leiterplatten (572) von dem Bestückautomaten (500) eingelesen werden.

9. Verfahren nach einem der Ansprüche 1 bis 8, bei dem
mit dem Identifizieren des Produktwechsel-Identifikationselementes (550) der Bestückautomat (500) zu einem vorbestimmten Produktwechsel-Sonderablauf veranlasst wird.

10. Verfahren nach Anspruch 9, bei dem der Produktwechsel-Sonderablauf zumindest einen der folgenden Verfahrensschritte umfasst:
• Abführen des Produktwechsel-Identifikationselementes (550),
• Umschalten des Bestückprogramms von dem ersten Bestückprogramm auf das zweite Bestückprogramm,
• Ausgabe einer Produktwechsel-Information an einer Anzeigeeinrichtung,
• Übergabe einer Produktwechsel-Information an eine Steuereinrichtung (580) des Bestückautomaten (500), und
• Fortsetzung der Bestückung mit dem zweiten Bestückprogramm.

11. Bestückautomat zum Bestücken von Leiterplatten (571, 572) mit Bauelementen, aufweisend einen Prozessor (580), der derart eingerichtet ist, dass das Verfahren nach einem der Ansprüche 1 bis 10 durchführbar ist.

12. Computerlesbares Speichermedium, in dem ein Programm zum Bestücken von Leiterplatten (571, 572) mit Bauelementen gespeichert ist, das, wenn es von einem Prozessor (580) ausgeführt wird, zum Durchführen des Verfahrens nach einem der Ansprüche 1 bis 10 eingerichtet ist.

13. Programm-Element zum Bestücken von Leiterplatten (571, 572) mit Bauelementen, das, wenn es von einem Prozessor ausgeführt wird, zum Durchführen des Verfahrens nach einem der Ansprüche 1 bis 10 eingerichtet ist.
